# EUROPEAN PATENT APPLICATION

(11) **EP 4 332 471 A1**
(43) Date of publication of application: **06.03.2024**
(21) Application number: 22382820.3
(22) Date of filing: 02.09.2022
(51) Int. Cl.: F25D 17/02, F25D 31/00, F25B 25/00

(54) **SYSTEM AND METHOD FOR REFRIGERATION AND THERMAL CONDITIONING OF A BODY**

(71) Applicant: Premo, SL, 29590 Campanillas, Málaga (ES)
(72) Inventor: CAÑETE CABEZA, Claudio, 29631 Benalmadena (ES); NAVARRO PÉREZ, Francisco Ezequiel, 08006 Barcelona (ES); ROJAS CUEVAS, Antonio, 29190 Málaga (ES); PERALES PADILLA, Javier, 41927 Mairena del Aljarafe (ES)
(74) Representative: Torner, Juncosa I Associats, SL

(57) **Abstract**

The invention provides a system and a method for refrigeration and thermal conditioning of a body. The system comprises a first circuit for refrigeration of the body and a second circuit for thermal conditioning of the body. The first circuit comprises a first reservoir for storage of a cold liquid coolant component and a first pump for pumping the cold coolant component from the first reservoir to a portion of the body, and for returning the cold coolant component to the first reservoir. The second circuit comprises a second reservoir for storage of a hot liquid coolant component and a second pump for pumping the hot coolant component from the second reservoir to the portion of the body, and for returning the hot coolant component to the second reservoir once the coolant has been applied, for a given time, to said portion of the body. A machine for making ice cubes is also provided.

## Description

### Technical Field

The present invention generally relates to a system and to a method for refrigeration and thermal conditioning of a body, for example, an ice bucket, a battery for an electric vehicle, a magnetic component, etc. The invention also relates to a machine for making ice cubes incorporating the mentioned system for refrigeration and thermal conditioning.

### Background of the Invention

A refrigeration system with a single reservoir which pulls heat out of a battery is known from patent application CN209374610. When the coolant has been heated and there is still a need for refrigeration, a cooling TEC module is activated. The TEC module is also used for heating the battery.

Likewise, an open type constant-temperature water conditioner for charging and swapping stations is known from patent document CN209445648U. In this case, a water or ethylene glycol reservoir cooled with a compressor, similar to the first reservoir of the present invention, is used, although for heating, an electric or infrared heater is used.

Moreover, and in relation to machines for making ice cubes, international patent application WO2014049179 describes a method and a device for rapid freezing of ice cubes. The ice cube defrosting system consists of electrical resistors located on the outer walls of the ice cube housing. These cables and resistors are in contact with the coolant, increasing the risk of a short circuit and negatively affecting the efficiency of the device given that the heating of the ice cube is slower, and given that most of the heat is not transmitted to the ice cube, but rather to the glycol, which is at a lower temperature. Also, in different subsystems of the device there is contact between copper and water (or a mixture of glycol and water), which are known to have poor compatibility, and the connections of the glycol lines to the ice bucket are made within the wet area of the device, which increases the risk of leaks that would contaminate the water, a critical failure that would affect the healthfulness of the ice.

Other devices for the production and rapid freezing of ice cubes are also known from the following patents: US9291381 (B2), EP2733445 (B1), US10480842 (B2) and US10132552 (B2).

Despite the known solutions in the state of the art, there is no known system for refrigeration and thermal conditioning that avoids the use of electrical heating means and uses in particular two coolant reservoirs at different temperatures, one cold and the other hot, alternating or combined.

Therefore, more efficient systems and methods for refrigeration and thermal conditioning are required to achieve wide-ranging high temperature variations in short periods of time.

### Disclosure of the Invention

To that end, the embodiments of the present invention provide, according to a first aspect, a system for refrigeration and thermal conditioning of a body, as defined in claim 1.

The proposed system comprises a body to be refrigerated and thermally conditioned; a first circuit for refrigeration of the body and a second circuit for thermal conditioning of the body.

According to the present invention, the first circuit includes a first reservoir for storage of a liquid coolant component, for example, glycol, among others. The first reservoir is for keeping the coolant component at a certain temperature which keeps it cold within a first given temperature range, for example, between -20ºC and -30ºC. Likewise, the first circuit includes a first pump for pumping the cold coolant component from inside the first reservoir to at least one portion of the body, and for returning the cold coolant component to the first reservoir once the coolant component has been applied to said portion of the body, which is at least one in number.

Moreover, the second circuit also includes a second reservoir for storage of a liquid coolant component, for example, glycol, among others. The second reservoir is configured for maintaining the coolant component at a certain temperature that keeps it hot within a second given temperature range, depending on the type of application. Likewise, the second circuit includes a second pump for pumping the hot coolant component from inside the second reservoir to the portion of the body, and for returning the hot coolant component to the second reservoir once the coolant component has been applied, for a given period of time, to the portion of the body.

Particularly, the first circuit and the second circuit are configured for operating in an alternating manner during the refrigeration and subsequent thermal conditioning.

Embodiments of the present invention also provide, according to a second aspect, a method for refrigeration and thermal conditioning of a body. The method comprises: refrigerating a body by means of applying a cold liquid coolant component in at least one portion of the body, wherein the cold coolant component is applied by means of a first circuit of a system for refrigeration and thermal conditioning, said first circuit comprising: a first reservoir for storage of the coolant component at a certain temperature which keeps it cold within a first given temperature range; and a first pump for pumping the cold coolant component from inside the first reservoir to the portion of the body, which is at least one in number; returning the cold coolant component to the first reservoir once it has been applied to said portion of the body; thermally conditioning the body by means of applying a hot liquid coolant component in said portion of the body, wherein the hot coolant component is applied by means of a second circuit of the system for refrigeration, said second circuit comprising: a second reservoir for storage of the coolant component at a certain temperature which keeps it hot within a second given temperature range, and a second pump for pumping the hot coolant component from inside the second reservoir to said portion of the body; and returning the hot coolant component to the second reservoir, through the second circuit, once it has been applied to said portion of the body for a predetermined period of time, wherein the first circuit and the second circuit operate in an alternating manner during refrigeration and thermal conditioning.

According to the present invention, the body to be refrigerated and thermally conditioned may comprise: a battery for an electric vehicle, a power electronic component such as a transformer or a capacitor, an ice bucket with a series of trays for making ice cubes, etc.

In one embodiment, the system further comprises a condensation unit, and the second circuit comprises a heat recovery element for recovering heat from the thermal energy generated in the condensation unit. This thermal energy is used to heat the coolant component at said second given temperature range.

In a particular embodiment, the body comprises an ice bucket with a series of trays for making ice cubes, with a section of the first circuit being in thermal contact with walls of the trays and/or extending between gaps in the trays. In this case, the first circuit further comprises, a pre-cooling reservoir for collecting water melted from the body due to thermal conditioning.

In some embodiments, the pre-cooling reservoir incorporates a detachable cover with slots which block the passage of the ice cubes; and a body with an interior comprising a plurality of fins to facilitate a heat exchange with the melted water and a double bottom through which the coolant component coming from the first reservoir is introduced.

In some embodiments, the system also includes a storage bin, arranged below the pre-cooling reservoir, comprising a perforated base, a water inlet, a water outlet, a cold coolant component inlet and a cold coolant component outlet.

In some embodiments, the mentioned bin is part of the pre-cooling reservoir itself.

In some embodiments, the ice bucket is fixed and comprises a lower base or portion adapted and configured for opening through at least one side joint of the lower base or portion, allowing the ice cubes made to be discharged.

In some embodiments, the system for refrigeration and thermal conditioning includes one or more electrovalves and/or one or more temperature sensors. In some embodiments, an automated control system, preferably with a display, and wireless and/or network connectivity, is also included.

Lastly, a third aspect of the invention provides a machine for making ice cubes that comprises the system for refrigeration and thermal conditioning of the first aspect of the invention, with the body to be refrigerated and thermally conditioned being an ice bucket with a series of trays for making ice cubes.

In a particular embodiment, the system for refrigeration further comprises a condensation unit; the first circuit further comprises a pre-cooling reservoir for collecting water melted from the body due to thermal conditioning; and the second circuit further comprises a heat recovery element for recovering heat from a thermal energy generated in the condensation unit, with said thermal energy being used to heat the coolant component.

### Brief Description of the Drawings

The above and other features and advantages will be better understood from the following detailed merely illustrative and non-limiting description of the embodiments in reference to the attached drawings, wherein:
Fig. 1 schematically shows a view of the components and connections of a system for refrigeration and thermal conditioning, according to one embodiment of the present invention.
Fig. 2 schematically shows a view of the components and connections of another system for refrigeration and thermal conditioning, according to another embodiment of the present invention.
Fig. 3 schematically shows the different components and connections of a machine for making ice cubes, according to another embodiment of the present invention.
Fig. 4 is a view of the inside of the machine for making ice cubes, according to another embodiment of the present invention.
Fig. 5 shows an embodiment of the ice bucket to be refrigerated and thermally conditioned by the proposed system for refrigeration and thermal conditioning.
Fig. 6 shows an embodiment of the pre-cooling reservoir used by the proposed system for refrigeration and thermal conditioning.
Fig. 7 shows an embodiment of the storage bin used by the proposed system for refrigeration and thermal conditioning.
Fig. 8 is a view of a magnetic component having a liquid coolant component associated therewith on a surface or going through one of its walls, according to another embodiment of the present invention.

### Detailed Description of the Invention and Embodiments

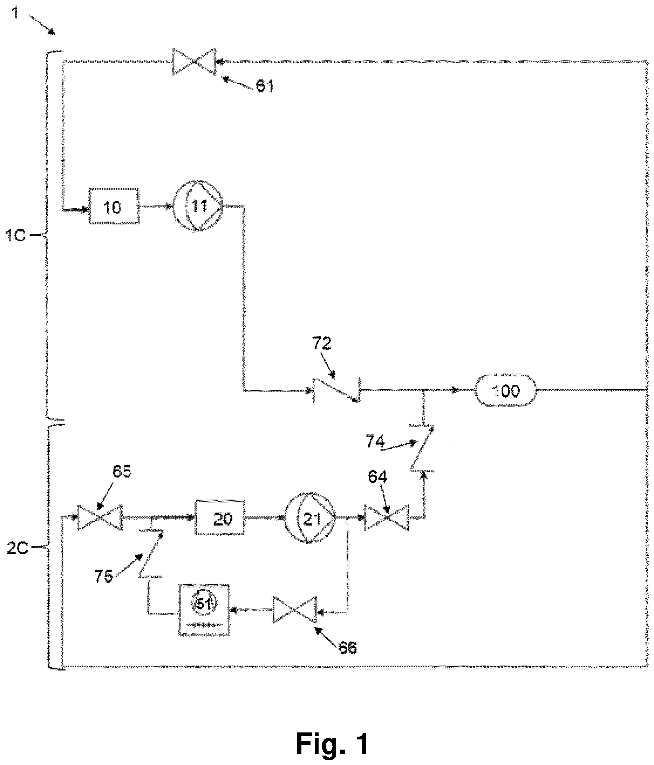

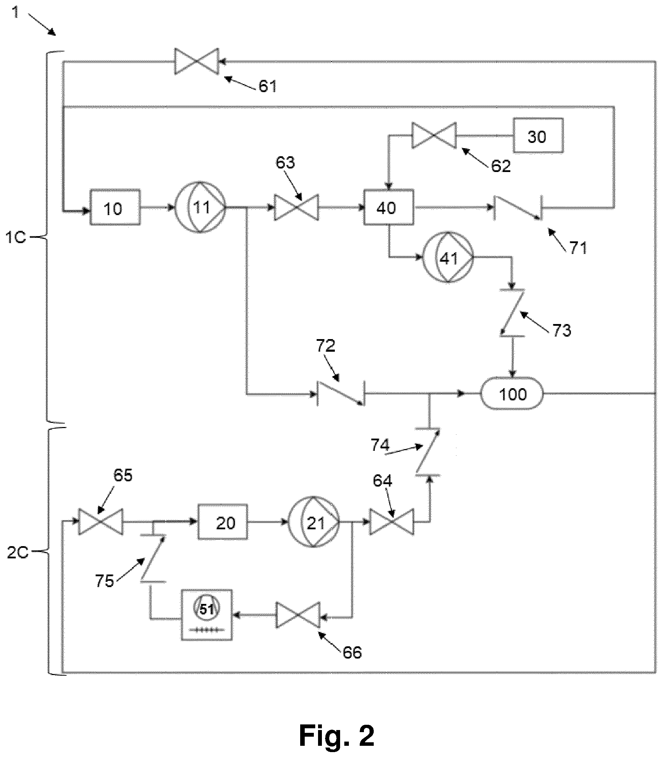

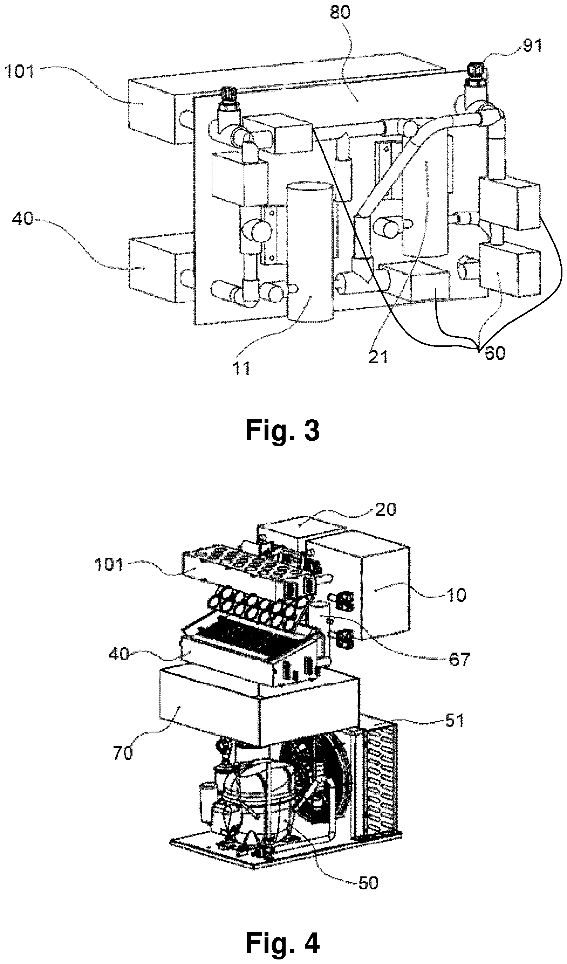

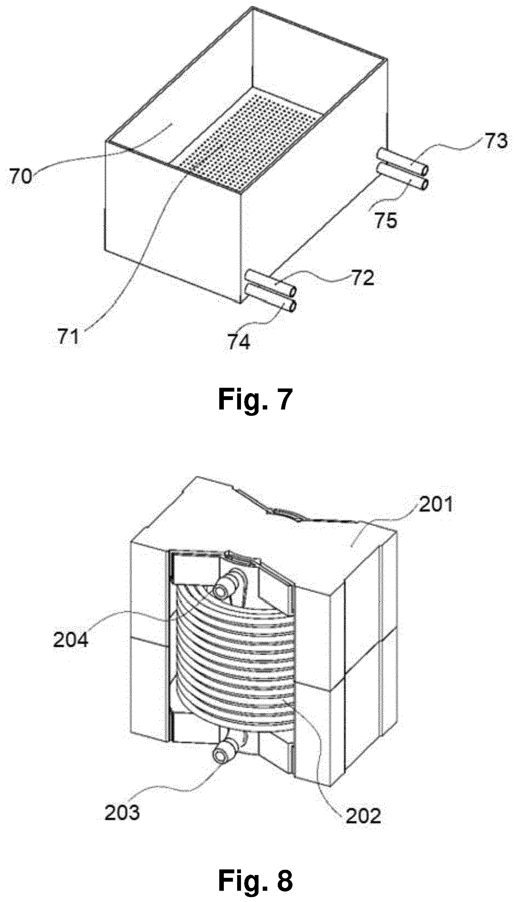

In reference to Figs. 1 and 2, shown therein are two embodiments of the components and connections of the proposed system 1 for refrigeration and thermal conditioning of a body, for example, an ice bucket 101 with a series of trays for making ice cubes (see Fig. 3 for one example), a battery for an electric vehicle (not illustrated), a magnetic component (see Fig. 8 for an example).

According to the embodiment of Fig. 1, the system 1 comprises two circuits which can operate in an alternating manner during refrigeration and thermal conditioning of the body 100. The first circuit 1C is used for refrigerating the body 100 and comprises a cold coolant reservoir, or first reservoir, 10; a cold coolant pump, or first pump, 11; a cold-body coolant non-return valve 72; and body-cold coolant electrovalve 61. Moreover, the second circuit 2C is used for thermally conditioning, or tempering, the body 100 and comprises a hot coolant reservoir, or second reservoir, 20; a hot coolant pump, or second pump, 21; a hot coolant-body non-return valve 74; a hot coolant-body electrovalve 64; and a body-hot coolant electrovalve 65.

Particularly, the second circuit 2C also comprises a heat recovery element 51 for recovering the heat expelled by a condensation unit 50 (see Fig. 7 for an example) with its corresponding electrovalve 66 and non-return valve 75.

According to the embodiment of Fig. 2, in this case, in addition to the elements of Fig. 1 described above, the system 1 further comprises a pre-cooling reservoir 40 for collecting water melted from the body 100 due to thermal conditioning, with its corresponding cold water pump 41 and a cold water-body non-return valve 73; a cold coolant-cold water electrovalve 63 between the cold coolant pump 11 and the pre-cooling reservoir 40; a cold water-cold coolant non-return valve 71; and a water reservoir 30 with a connection to the pre-cooling reservoir 40 by means of a water intake-cold water reservoir electrovalve 62.

Now referring to Figs. 3 and 4, said figures show an embodiment of the proposed machine for making ice cubes. The machine incorporates the system 1 for refrigeration and thermal conditioning. As observed in Figs. 3 and 4, the machine comprises, attached to a fixing panel 80: an ice bucket 101; the pre-cooling reservoir 40; a storage bin 70; the condensation unit 50; the heat recovery element 51; the two cold and hot coolant reservoirs 10, 20, respectively, with their corresponding pumps 11, 21 and electrovalves 60 (including electrovalves 61-66); an electromechanical component 67; and temperature sensors 91, which allow the condition of the machine to be known.

Though not illustrated in the figures, for the sake of simplicity, the electrical components of the machine, for example, relays, power supplies, automated control system, etc., are located in an isolated enclosure intended to be installed inside the machine, thereby avoiding short circuits caused by possible leaks or dripping of frost.

With the implementation of the second circuit 2C, the ice bucket 101 is tempered, for its defrosting, using the hot coolant, for example, glycol, among others, instead of by means of using electrical resistors on the outer faces of the ice cube housing. Furthermore, the cold coolant can be discharged minimizing the thermal conditioning time (about 1 minute). The heating of the hot coolant is performed by means of the heat recovery element 51 which recovers the heat expelled by the condensation unit 50. The heat expelled by the condensation unit 50 is thereby utilized, reducing the use of electrical resistors for heating the coolants, and expulsion of heat to the exterior is reduced.

Likewise, the pre-cooling reservoir 40 has a positive impact on total water utilization, on better energy utilization, and on improved machine performance. For example, the pre-cooling reservoir 40 allows all the water to be utilized, avoiding the draining of water that thaws during defrosting. Furthermore, the water melted during defrosting is colder than the water in the cold water reservoir 30 (usually at room temperature), so utilizing it also represents energy savings.

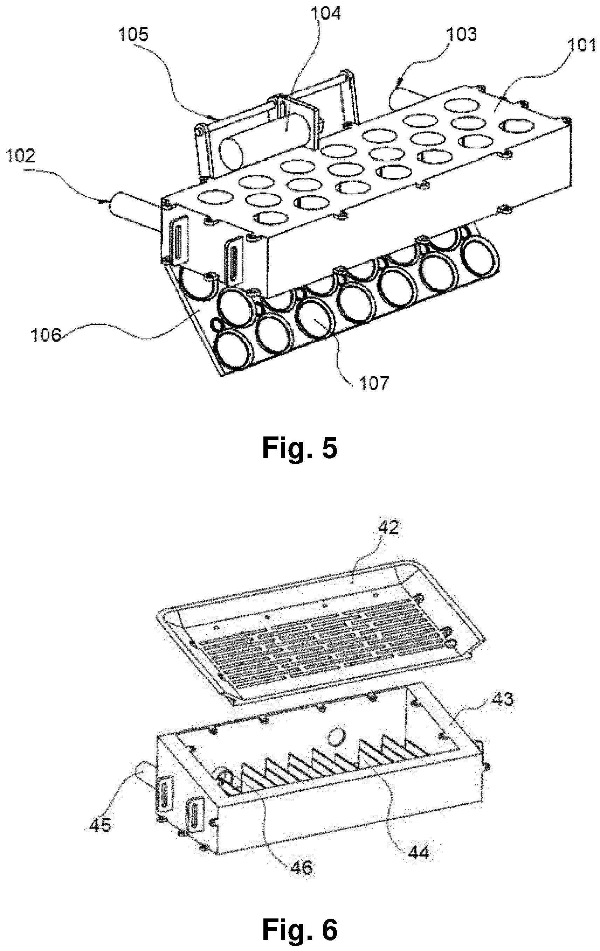

Fig. 5 shows an embodiment of the ice bucket 101. According to this example, the ice bucket 101 includes a coolant inlet 102, a coolant outlet 103, a motor 104 and an opening mechanism 105. Furthermore, particularly according to the present invention, the ice bucket 101 also includes a lower portion 106 with sealing gaskets 107. The lower portion 106 can open and close, thereby allowing the ice cubes made to be discharged into the ice bucket 101.

Fig. 6 shows an embodiment of the pre-cooling reservoir 40, and Fig. 7 shows an embodiment of the storage bin 70. It should be mentioned that although in the embodiments described above, both elements are separate, in other embodiments, these elements can be part of a single element that implements both functions, thereby reducing the size and cost of the machine, as an element is eliminated; refrigeration of the storage bin 70 is allowed, improving the conservation of the ice cube; and if the stored ice cubes partially melt, the liquid water will be utilized.

The pre-cooling reservoir 40 illustrated in Fig. 6 comprises a cover 42 with slots which prevent the passage of the ice cubes made into the ice bucket 101, and a body 43 with an interior comprising a double bottom into which the cold coolant component is introduced through the inlet 45. A series of fins 44 facilitating the heat exchange with the melted water, and also holes 46 for sensors, are included in the interior of the pre-cooling reservoir 40.

The storage bin 70, in turn, comprises a perforated base 71, a water inlet 72, a water outlet 73, a cold coolant inlet 74 and a cold coolant outlet 75.

The proposed machine for making ice cubes also incorporates an automated control system with a display and with wireless and/or network IP connectivity. This allows the parameters of the machine to be modified remotely, maintenance tasks to be performed remotely, and scheduling of the various operating modes to be performed remotely.

The machine can also incorporate various operating modes, such as:
- ECO mode: This mode modifies the temperatures and times of the machine in order to maximize the energy efficiency of the machine, to the detriment of production. It is ideal for lower-demand situations in which energy savings are a determining factor. Prior to the first cycle, the machine takes time to cool the water reservoir 30 and coolant reservoirs 10, 20.
- MAX mode: This mode seeks to maximize daily ice production, regardless of power consumption. Prior to the first cycle, the machine takes time to cool the water reservoir 30 and coolant reservoirs 10, 20.
- FAST mode: Consumers will use this mode when they need to produce an ice bucket with ice urgently. This mode avoids "wasting time" to cool the pre-cooling reservoir 40, and the cold coolant will begin to circulate when the machine is switched on.
- SAVER mode: With this mode, the machine obtains, through an API, the prices of electricity (€/kWh) at all times of the day. Users can define the amount of ice they will need and when they will consume it. The machine will thereby be activated at the time of day when the cost of electricity is the lowest.

The characteristics of high energy efficiency, low volume and low weight in the systems for refrigeration described as an example are likewise directly applicable to the power electronics and batteries in the electric vehicle.

In the case of the power electronics, the use of coolant, glycol, for example, at a very low temperature (about -30º) in components such as transformers or capacitors, allows the energy losses of these components to be reduced. Furthermore, the concept of phase change can also be used for the refrigeration of these components. Fig. 8 illustrates an example of a ferromagnetic core 201 including a winding 202 and a respective coolant inlet 203 and a respective coolant outlet 204.

In the case of batteries, the use of coolant at a very low temperature allows materials to be used in the batteries that would not be possible to use at very high temperatures. Furthermore, the batteries need to be tempered, so refrigeration needs are dependent on conditions outside the electric vehicle. With the proposed system 1 for refrigeration and thermal conditioning, by including two coolant reservoirs 10, 20 at different temperatures, in an alternating or combined manner as a result of the pumps 11, 21 and electrovalves, temperatures in a high range can be achieved in short periods of time.

The scope of the present invention is defined in the attached claims.

## Claims

1. A system for refrigeration and thermal conditioning of a body, which system comprises:
a body (10) to be refrigerated and thermally conditioned;
a first circuit (1C) for refrigeration of the body (100), wherein the first circuit (1C) comprises:
- a first reservoir (10) for storage of a liquid coolant component, wherein said first reservoir (10) is configured for maintaining the coolant component at a certain temperature that keeps it cold within a first given temperature range;
- a first pump (11) configured for pumping the cold coolant component from inside the first reservoir (10) to at least one portion of the body (100), and for returning the cold coolant component to the first reservoir (10) once the coolant component has been applied to said portion of the body, which is at least one in number;
**characterized in that** it further comprises:
a second circuit (2C) for thermal conditioning of the body (100), wherein the second circuit (2C) comprises:
- a second reservoir (20) for storage of a liquid coolant component, wherein said second reservoir (20) is configured for maintaining the coolant component at a certain temperature that keeps it hot within a second given temperature range;
- a second pump (21) configured for pumping the hot coolant component from inside the second reservoir (20) to the portion of the body (100), and for returning the hot coolant component to the second reservoir (20) once the coolant component has been applied, for a given period of time, to the portion of the body (100),
wherein the first circuit (1C) and the second circuit (2C) are configured for operating in an alternating manner during refrigeration and thermal conditioning.

2. The system according to claim 1, further comprising a condensation unit (50), wherein the second circuit also comprises a heat recovery element (51) for recovering heat from a thermal energy generated in the condensation unit (50), with said thermal energy being used to heat the coolant component at said second given temperature range.

3. The system according to any one of the preceding claims, wherein the body (100) comprises an ice bucket (101) with a series of trays for making ice cubes and wherein said portion is in thermal contact with walls of the trays and/or extends between gaps in the trays.

4. The system according to claim 3, wherein the first circuit (1C) further comprises a pre-cooling reservoir (40) configured to collect water melted from the body (100) due to thermal conditioning.

5. The system according to claim 4, wherein the pre-cooling reservoir (40) comprises a detachable cover (42) with slots, and a body (43) with an interior comprising a double bottom through which the coolant component coming from the first reservoir (10) is introduced, and a plurality of fins (44) to facilitate a heat exchange with the melted water.

6. The system according to claim 4 or 5, further comprising a storage bin (70) arranged below the pre-cooling reservoir (40), wherein the storage bin (70) comprises: a perforated base (71), a water inlet (72), a water outlet (73), a cold coolant component inlet (74), and a cold coolant component outlet (75).

7. The system according to claim 3, 4, 5 or 6, wherein the ice bucket (101) is fixed and comprises a lower base or portion (106) adapted and configured for opening through at least one side joint of the lower base or portion (106), allowing the ice cubes made to be discharged.

8. The system according to claim 1 or 2, wherein the body (100) comprises a battery for an electric vehicle or a power electronic component, including a transformer or a capacitor.

9. The system according to any one of the preceding claims, further comprising one or more electrovalves (60, 61, 62, 63, 64, 65) and one or more temperature sensors (91) for monitoring an operating state of the system (1) for refrigeration and thermal conditioning.

10. The system according to any one of the preceding claims, further comprising an automated control system, with a display and wireless and/or network connectivity.

11. The system according to any one of the preceding claims, wherein the coolant component comprises glycol.

12. A machine for making ice cubes, wherein the machine comprises the system (1) for refrigeration and thermal conditioning of claim 1, with the body (100) to be refrigerated and thermally conditioned being an ice bucket (101) with a series of trays for making ice cubes.

13. The machine according to claim 12, wherein:
the system (1) for refrigeration and thermal conditioning further comprises a condensation unit (50);
the first circuit (1C) further comprises a pre-cooling reservoir (40) configured for collecting water melted from the ice bucket (101) due to thermal conditioning; and
the second circuit (2C) further comprises a heat recovery element (51) for recovering heat from a thermal energy generated in the condensation unit (50), with said thermal energy being used to heat the coolant component.

14. A method for refrigeration and thermal conditioning of a body, which method comprises:
refrigerating a body by means of applying a cold liquid coolant component in at least one portion of the body, wherein the cold coolant component is applied by means of a first circuit of a system for refrigeration and thermal conditioning, said first circuit comprising: a first reservoir for storage of the coolant component at a certain temperature which keeps it cold within a first given temperature range; and a first pump for pumping the cold coolant component from inside the first reservoir to the portion of the body, which is at least one in number;
returning the cold coolant component to the first reservoir, through the first circuit, once it has been applied to said portion of the body;
**characterized in that** it further comprises:
thermally conditioning the body by means of applying a hot liquid coolant component in said portion of the body, wherein the hot coolant component is applied by means of a second circuit of the system for refrigeration, said second circuit comprising: a second reservoir for storage of the coolant component at a certain temperature which keeps it hot within a second given temperature range; and a second pump for pumping the hot coolant component from inside the second reservoir to said portion of the body; and
returning the hot coolant component to the second reservoir, through the second circuit, once it has been applied to said portion of the body,
wherein the first circuit and the second circuit operate in an alternating manner during refrigeration and thermal conditioning.

15. The method according to claim 14, wherein the body comprises an ice bucket with a series of trays for making ice cubes, and wherein the method further comprises:
collecting, with a pre-cooling reservoir of the first circuit, water melted from the body due to thermal conditioning; and
recovering, with a heat recovery element of the second circuit, a thermal energy generated in a condensation unit of the system for refrigeration and thermal conditioning and using the recovered thermal energy to heat the coolant component at said second given temperature range.
